(19) Europäisches Patentamt
European Patent Office
Office européen des brevets

(11) Veröffentlichungsnummer: **0 224 164 B1**

(12) # EUROPÄISCHE PATENTSCHRIFT

(45) Veröffentlichungstag der Patentschrift: **27.06.90**

(51) Int. Cl.⁵: **G03F 7/032**

(21) Anmeldenummer: **86115918.4**

(22) Anmeldetag: **17.11.86**

(54) **Photoempfindliche Aufzeichnungsmaterialien mit elastomeren Pfropfcopolymerisat-Bindemitteln sowie Reliefformen daraus.**

(30) Priorität: **21.11.85 DE 3541162**

(43) Veröffentlichungstag der Anmeldung: **03.06.87 Patentblatt 87/23**

(45) Bekanntmachung des Hinweises auf die Patenterteilung: **27.06.90 Patentblatt 90/26**

(84) Benannte Vertragsstaaten: **AT BE CH DE ES FR GB IT LI NL SE**

(56) Entgegenhaltungen:
**EP-A- 0 010 690**
**EP-A- 0 079 514**
**GB-A- 815 277**
**US-A- 4 517 277**
**US-A- 4 540 743**

(73) Patentinhaber: **BASF Aktiengesellschaft, Carl-Bosch-Strasse 38, D-6700 Ludwigshafen(DE)**

(72) Erfinder: **Hoffmann, Gerhard, Dr., Pappelstrasse 22, D-6701 Otterstadt(DE)**
Erfinder: **Koch, Horst, Dr., Schliffgasse 22, D-6711 Grosskarlbach(DE)**
Erfinder: **Schulz, Günther, Dr., Wasgaustrasse 24, D-6700 Ludwigshafen(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 224 164 B1

**Beschreibung**

Die Erfindung betrifft in wäßrigen Lösungsmitteln entwickelbare photoempfindliche Aufzeichnungsmaterialien aus einem in einem wäßrigen Lösungsmittel löslichen oder dispergierbaren elastomeren polymeren Bindemittel, gegebenenfalls damit verträglichen photopolymerisierbaren Monomeren sowie einem Photoinitiator für die Herstellung von Reliefformen, insbesondere Druckformen für den Flexodruck.

Photoempfindliche Aufzeichnungsmaterialien mit elastomeren Bindemitteln, photopolymerisierbaren Monomeren und Photoinitiatoren sind z.B. in der DE-OS 3 012 841, US-PS 4 415 649, US-PS 3 825 430 und der E-PS 104 751 beschrieben. Damit hergestellte Flexodruckplatten lassen sich nach bildmäßiger Belichtung jedoch nur mit Hilfe größerer Anteile von organischen Lösungsmitteln entwickeln. In der US-PS 4 247 624 werden zwar photoempfindliche elastomere Mischungen für die Herstellung von flexographischen Druckplatten beschrieben, die wasserlösliche Elastomere auf der Basis von carbaminierten Polyvinylalkoholderivaten als Bindemittel enthalten, jedoch sind diese Elastomeren schwierig herstellbar und isolierbar.

Der Erfindung lag die Aufgabe zugrunde, für in wäßrigen Lösungsmitteln entwickelbare photovernetzbare oder photopolymerisierbare Aufzeichnungsmaterialien elastomere polymere Bindemittel zu finden, die in wäßrigen Lösungsmitteln löslich oder dispergierbar, unschwierig herstellbar sind und Reliefformen für den Flexodruck einschließlich Zeitungsflexodruck mit vorteilhaften Eigenschaften ergeben.

Die erfindungsgemäße Lösung der Aufgabe sind in wäßrigen Lösungsmitteln entwickelbare, photovernetzbare oder photopolymerisierbare elastomere Aufzeichnungsmaterialien enthaltend

a) mindestens ein polymeres Bindemittel,
b) gegebenenfalls mindestens eine mit dem Bindemittel verträgliche photopolymerisierbare olefinisch ungesättigte Verbindung sowie
c) mindestens einen Photoinitiator,

die als polymeres Bindemittel ein in einem wäßrigen Lösungsmittel lösliches oder dispergierbares elastomeres Pfropfpolymerisat enthalten, das durch Polymerisation von Vinylestern in Gegenwart von Polyalkylenoxiden und einem Initiator der radikalischen Polymerisation, Verseifen oder Teilverseifen der resultierenden Pfropfcopolymerisate und gegebenenfalls anschließendes Verestern oder Umestern von Vinylalkohol-Einheiten des verseiften oder teilverseiften Pfropfcopolymerisats hergestellt ist und im wesentlichen besteht aus Struktureinheiten der Zusammensetzung

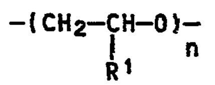 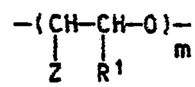 ,

worin Z: aufgepfropfte Seitenzweige mit Struktureinheiten

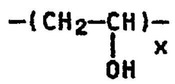 und ggf. 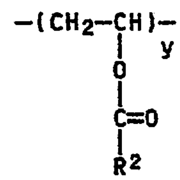 ,

$R^1$ Wasserstoff und/oder Alkylreste mit 1 oder 2 C-Atomen,
$R^2$ Alkyl- und/oder Alkenylreste, gegebenenfalls mit Carboxylsubstituenten, darstellen,
und $x > y$, $n > m$, m mindestens 2, $n + m = 20\text{-}2000$, bevorzugt 50-1000 und

$$\frac{(n+m)}{(x+y)} = \frac{1}{4} \text{ bis } \frac{3}{1}, \text{ bevorzugt } \frac{2}{3} \text{ bis } \frac{2}{1} \text{ sind.}$$

Die erfindungsgemäß verwendeten modifizierten Pfropfcopolymerisate werden in erster Stufe durch Polymerisation von Vinylestern in Gegenwart von Polyalkylenoxiden und einem Initiator der radikalischen Polymerisation in Mengenverhältnissen hergestellt, die sich aus den angegebenen Mengenangaben zu der Zusammensetzung der Struktureinheiten ergeben. Als Vinylester kommen die üblichen Vinylester von aliphatischen Monocarbonsäuren mit 2 bis 18 C-Atomen in Frage, bevorzugt ist Vinylacetat. Als Polyalkylenoxide kommen bevorzugt Copolymere von Propylenoxid und Ethylenoxid mit mindestens 50 Mol.% Ethylenoxid und insbesondere Polyethylenoxide in Frage. Bei den Copolymeren können die Alkylenoxid-Einheiten statistisch verteilt oder in Form von Blöcken vorliegen, z.B. Blockcopolymerisate

von Ethylenoxid und Propylenoxid darstellen. Die Zahlenmittel der Molekulargewichte geeigneter Polyalkylenoxide liegen im allgemeinen bei ca. 1.000 bis 100.000 bevorzugt bei ca.4.000 bis 50.000.

Als Initiatoren der radikalischen Polymerisation können die bekannten in üblichen Mengen verwendet werden, z.B. Peroxide wie Diacetylperoxid, Dibenzoylperoxid, Succinylperoxid, Di-tert.butyl-peroxid, Dilaurylperoxid, tert.-Butylperbenzoat oder tert.-Butylhydroperoxid, ferner Azobisisobutyronitril oder Mischungen bekannter Initiatoren. Bevorzugt sind Benzoyl- und Laurylperoxid. Die Initiatoren werden in Mengen von etwa 0,1 bis 10, insbesondere von 0,2 bis 2 und bevorzugt von 0,5 bis 1,5 Gew.% der Menge an Vinylester verwendet.

Als Polymerisationstemperatur des Vinylesters in Gegenwart der Polyalkylenoxide wird vorteilhaft eine Temperatur von 50 bis 150°C, bevorzugt von 80 bis 120°C, gewählt.

Zur Herstellung der Pfropfpolymerisate können die Polyalkylenoxide im Vinylester gelöst und nach Zugabe des Initiators kontinuierlich oder diskontinuierlich polymerisiert werden. Besonders bewährt hat es sich, die Pfropfcopolymerisation der Vinylester in Gegenwart der Polyalkylenoxide so durchzuführen, daß die Monomerenkonzentration während der Polymerisation möglichst gering bleibt. Dies kann vorteilhaft so erfolgen, daß man die Polyalkylenoxide vorlegt, auf Polymerisationstemperatur erwärmt und ein Vinylester-Initiator-Gemisch absatzweise oder bevorzugt kontinuierlich langsam zugibt. Bewährt hat sich ein Zulauf bei 90°C während etwa 2 bis 6 Stunden. Günstig ist es, die Pfropfpolymerisation in Abwesenheit eines Lösungsmittels, bevorzugt ist es, sie in geschmolzenem Polyalkylenoxid durchzuführen. Die resultierenden Pfropfcopolymerisate haben im allgemeinen einen K-Wert nach H. Fikentscher von 10 bis 200, vorzugsweise von 20 bis 100 (bestimmt in 1 gew.%iger Lösung in Ethylacetat bei 25°C). Im resultierenden Pfropfcopolymerisat soll die Zahl der ungepfropften Alkylenoxid-Struktureinheiten (n) gegenüber den gepfropften (m) überwiegen, jedoch muß m mindestens 2 sein. Die Menge an aufgepfropften Vinylester soll im allgemeinen die 1/3 bis 4fache molare Menge der Molmenge an Alkylenoxid-Struktureinheiten im vorgelegten Polyalkylenoxid, insbesondere 30-60 Mol.% des Pfropfcopolymerisats sein.

Danach können die Estergruppen im resultierenden Pfropfcopolymerisat in bekannter Weise ganz oder teilweise durch Zugabe einer Base wie Natronlauge oder Kalilauge oder durch Zugabe einer Säure verseift werden, wobei unter Verseifung oder Teilverseifung auch eine Umesterung verstanden werden soll, bei der Vinylalkohol-Struktureinheiten entstehen. Als vorteilhaft hat sich die Umesterung mit 0,02 bis 2 % Natriumhydroxid (bezogen auf die Menge an eingesetztem Vinylester) als Katalysator in 20 bis 60 gew.%iger methanolischer Lösung des Pfropfcopolymerisats bei 20-30°C erwiesen. Das dabei entstehende Gel wird durch Zugabe von Wasser gelöst und dann der Katalysator mit z.B. Essigsäure neutralisiert.

Der erstrebte Verseifungsgrad richtet sich neben Art des vorgelegten Polyalkylenoxids und Vinylesters vor allem nach der gewünschten Löslichkeit in wäßrigem Lösungsmittel bzw. Wasser allein. Im allgemeinen beträgt der Verseifungsgrad mindestens 50 Mol.%, bevorzugt etwa 65 bis 99 Mol.% der Vinylester-Struktureinheiten im Pfropfcopolymerisat. Bevorzugt beträgt der Anteil an $-CH_2-CH-O-CO-R^2$-Vinylestergruppen weniger als 20 und insbesondere weniger als 10 Mol.%.

Wünscht man die Herstellung von Pfropfcopolymerisaten, die seitenständige olefinisch ungesättigte Gruppierungen aufweisen und so die Photovernetzung der Pfropfcopolymerisate ermöglichen oder bei Mitverwendung photopolymerisierbarer Monomerer diese beschleunigen, so ist es zweckmäßig, solche Gruppen nach dem Verseifen oder Teilverseifen des Pfropfcopolymerisats durch Umsetzung von Hydroxylgruppen der Vinylalkohol-Struktureinheiten mit olefinisch ungesättigten Verbindungen, die mit Hydroxylgruppen umsetzbare reaktive Gruppen aufweisen, als Seitengruppen in das Polymere einzuführen. Dies kann z.B. durch Umsetzung mit Estern, einem Chlorid oder bevorzugt Anhydrid einer olefinisch ungesättigten Carbonsäure wie der Acrylsäure, Methacrylsäure, Crotonsäure oder Maleinsäure erfolgen. Verwiesen sei diesbezüglich auf die Angaben in den DE-OS 31 44 905 und DE-OS 33 22 993 oder die Beschreibung einer analogen Veresterung in z.B. den US-PS 2 929 710 und 3 427 161, der GB-PS 834 337 oder der DE-OS 15 22 359. Obwohl die Menge der so eingeführten seitenständigen Doppelbindungen von der gewünschten Wasserlöslichkeit und dem Verwendungszweck der Bindemittel bestimmt wird, haben sich Pfropfcopolymerisate mit einem Gehalt von etwa 2 bis 15 Mol.% an Acryl- und/oder Methacrylestergruppen als Bindemittel für wasserentwickelbare Aufzeichnungsmaterialien besonders bewährt. Sie lassen sich bei höherem Gehalt an ungesättigten Doppelbindungen zusammen mit Photoinitiatoren auch ohne oder mit nur sehr geringem Zusatz von photopolymerisierbaren Monomeren als photovernetzbare Aufzeichnungsmaterialien verwenden.

Die erfindungsgemäß verwendeten Pfropfcopolymerisate haben elastomere Eigenschaften, d.h. sie haben eine Glastemperatur von unter 20°C und bevorzugt von unter 0°C. Die Polymeren erlauben gummielastische (entropieelastische) Formänderungen. Sie weisen nach 100 % Dehnung und anschließender Entlastung eine Restdehnung von weniger als 30 und bevorzugt weniger als 20 %, z.B. 10-20 %, auf. Die Zugspannung für 100 % Dehnung, d.h. Dehnung auf die doppelte Länge, beträgt bevorzugt weniger als $10^7$Pa. Besonders geeignete Pfropfcopolymerisate weisen eine Bruchdehnung von mindestens 100 %, bevorzugt von mindestens 150 % auf. Natürlich ist es möglich, sie in Abmischung mit anderen verträglichen polymeren Bindemitteln für Aufzeichnungsmaterialien zu verwenden.

In den bevorzugten Ausführungsformen werden die Polymerbindemittel in Mischung mit mindestens einer mit dem Polymerbindemittel verträglichen photopolymerisierbaren olefinisch ungesättigten Verbindung unter Zusatz eines Photoinitiators zu photoempfindlichen Aufzeichnungsmaterialien verarbeitet. Als "verträglich" wird hierbei die Fähigkeit verschiedener Komponenten verstanden, ineinander dispergiert zu bleiben, ohne eine wesentliche Streuung von aktinischem Licht zu erzeugen. Mischungen unverträglicher Komponenten werden stark trüb. Geeignete Monomere mit ein oder mehr photopolymerisierbaren olefinisch ungesättigten Doppelbindungen sind z.B. die verträglichen Mono- und Di-acrylate und -methacrylate von mindestens zweiwertigen Alkoholen wie Ethylenglykol, Di-, Tri-, Tetra- oder Polyethylenglykolen, letztere bevorzugt mit 10 bis 15 Ethylenglykoleinheiten 1,3-Propandiol, Glycerin, 1,1,1-Trimethylolpropan, 1,2,4-Butantriol oder Pentaerythrit, z.B. Ethylenglykol-monomethacrylat, 1,3-Propandiolmonomethacrylat, Glycerin-mono- und -diacrylat, 1,2,4-Butantriol-monomethacrylat, Pentaerythrittriacrylat, ω-Methylpolyethylenglykol-monoacrylat, Tetradecaethylenglykol-dimethacrylat oder der Triether aus Glycerin und 3 Molen N-Methylolacrylamid oder -methacrylamid. Die Menge an zugemischtem Monomeren liegt im allgemeinen bei etwa 5 bis 70, bevorzugt bei etwa 15 bis 40 Gew.% der Summe der Mischungskomponenten a) + b) und richtet sich nach Verträglichkeit und gewünschter Belichtungsdauer, Härte und sonstigen anwendungstechnischen Eigenschaften der Aufzeichnungsmaterialien bzw. der daraus hergestellten Reliefformen. Im allgemeinen sollen letztere elastomere Eigenschaften aufweisen.

Als Photoinitiatoren für die erfindungsgemäßen Aufzeichnungsmaterialien kommen die bekannten in Frage, die eine hinreichende thermische Stabilität bei der Verarbeitung der Aufzeichnungsmaterialien, eine hinreichende Radikalbildung bei Belichtung unter Initiierung einer Photopolymerisation der Monomeren b) oder Initiierung einer Photovernetzung der Polymeren mit seitenständigen ungesättigten Gruppen aufweisen. Sie sollen Strahlung im Wellenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z.B. Benzoinisopropylether, α-Methylolbenzoin und dessen Ether wie α-Methylolbenzoinmethylether, vicinale Diketone und deren Derivate, z.B. Benzil, Benzilacetale wie Benzildimethylketal und bevorzugt Acylphosphinoxid-Verbindungen wie 2,6-Dimethoxybenzoyldiphenylphosphinoxid und insbesondere 2,4,6-Trimethylbenzoyl-diphenylphosphinoxid. Die Photoinitiatoren lassen sich auch in bekannter Art in Mischungen mit einander oder in Verbindung mit Coinitiatoren bzw. Aktivatoren verwenden wie Michlers-Keton und seine Derivate oder 2-Alkylanthrachinone. Die Menge an Photoinitiator beträgt im allgemeinen etwa 0,01 bis 10, bevorzugt etwa 0,5 bis 5 Gew.% des Aufzeichnungsmaterials.

Oft ist es von Vorteil, dem Aufzeichnungsmaterial noch weitere Hilfs- und Zusatzstoffe zuzugeben wie Inhibitoren der thermischen Polymerisation wie Hydrochinon und seine Derivate, 2,6-Di-tert.butyl-p-kresol, Nitrophenole, Nitrosamine wie N-Nitrosodiphenylamin oder Salze des N-Nitrosocyclohexyl-hydroxylamins, z.B. deren Alkali- oder Aluminiumsalze. Weitere übliche Zusätze sind Farbstoffe, Pigmente, Verarbeitungshilfsmittel und Weichmacher. Besonders zeichnet sich das erfindungsgemäß verwendete Pfropfcopolymerisat durch seine gute Verträglichkeit mit Weichmachern wie Ethylenglykol, Polyethylenglykol, Glycerin, N-Alkyl-benzolsulfonamide oder Dialkylphthalate, die z.T. in Mengen von etwa 5 bis 40, bevorzugt von etwa 10 bis 30 Gew.% den Aufzeichnungsmaterialien zugemischt werden können.

Die erfindungsgemäßen Aufzeichnungsmaterialien lassen sich durch Mischen von Komponenten und Lösungsmitteln oder durch Mischen in Knetern oder Extrudern herstellen. Die homogenen Mischungen werden im allgemeinen in einer Dicke von 25 bis 6000 µm, bevorzugt 200 bis 300 µm, auf einen üblichen dimensionsstabilen Träger aufgebracht, wobei erforderlichenfals zwischen photoempfindlicher Aufzeichnungsschicht und Träger noch Zwischenschichten, z.B. zur Haftverbesserung vorhanden sein können. Geeignete Träger sind je nach Verwendungszweck z.B. Polyesterfolien, Stahl- oder Aluminiumbleche, Schaumstofflagen und gummielastische Träger. Es kann auch vorteilhaft sein, auf die photoempfindliche Aufzeichnungsschicht eine Deck- bzw. Schutzschicht aufzubringen, z.B. eine dünne Schicht aus Polyvinylalkohol oder Polyvinylalkohol-Polyethylenoxid-Copolymerisaten.

Die erfindungsgemäßen Aufzeichnungsmaterialien lassen sich in bekannter Weise zu Flachdruckplatten, Resisten sowie zu Reliefformen, insbesondere Druckformen, verarbeiten. Hierzu wird im allgemeinen die Schicht des photoempfindlichen Aufzeichnungsmaterials bildmäßig mit aktinischem Licht aus Lichtquellen wie UV-Fluoreszenzröhren, Quecksilberhoch-, -mittel- oder -niederdruckstrahlern, Leuchtstoffröhren etc. belichtet, wobei die emittierte Wellenlänge bevorzugt zwischen 300 und 420 nm liegt. Das Entfernen der unbelichteten und unvernetzten Schichtanteile kann durch Sprühen, Waschen, Bürsten etc. mit wäßrigen Lösungsmitteln oder Wasser erfolgen. Es ist ein Vorteil der bevorzugt erfindungsgemäß als Bindemittel verwendeten Pfropfcopolymerisate, daß sie ein Auswaschen mit reinem Wasser ohne Zusatz organischer Lösungsmittel erlauben. Zweckmäßig werden entwickelte Relief- und Druckformen bei Temperaturen bis zu 120°C getrocknet und gegebenenfalls gleichzeitig oder danach mit aktinischem Licht nachbelichtet.

Die aus erfindungsgemäßen Aufzeichnungsmaterialien hergestellten Druckformen eignen sich besonders für den Flexodruck, Zeitungsflexodruck und ähnliche Druckarten.

Die Erfindung wird durch nachstehende Versuche und Beispiele erläutert. Die darin genannten Teile und Prozente beziehen sich, soweit nicht anders angegeben, auf das Gewicht. Volumenteile verhalten sich zu Teilen wie Liter zu Kilogramm. Die Shore-Härte wurde gemessen nach DIN 53 505.

Herstellung von Pfropfcopolymerisaten

Versuch A

360 Teile Polyethylenoxid mit einem mittleren Molekulargewicht von 9000 g/Mol werden unter Stickstoff auf 90°C erwärmt und dabei aufgeschmolzen. Zu dieser Schmelze wird unter Rühren eine Lösung von 2 Teilen Benzoylperoxid in 440 Teilen Vinylacetat so schnell zugetropft, daß unumgesetztes Vinylacetat gerade eben zu schwachem Rückfluß führt. Anschließend wird in 4 bis 6 Stunden bei 90°C auspolymerisiert. Nach Abkühlen auf ca. 60°C werden 800 Teile Methanol zugegeben. Nach Abkühlung der entstehenden Lösung auf Raumtemperatur wird durch Zugabe von 24 Teilen einer 10 %ig-methanolischen Natronlauge die Umesterung der Acetatgruppen eingeleitet, in deren Verlauf die Lösung geliert. Nach einer Reaktionszeit von 8 bis 10 Stunden bei 20 bis 30°C wird das Gel durch Zugabe von 1400 Teilen Wasser gelöst, die Lösung mit Eisessig neutralisiert und das Produkt in einem großen Überschuß von Aceton ausgefällt. Aus Wasser vergossene Filme des Produktes zeigen gummielastisches Verhalten. Die Esterzahl des Produktes liegt bei 14 mg/g, die Restdehnung nach 50 % Dehnung und anschließender Entlastung bei 19 % und die Reißdehnung bei 14 MPa.

Versuch B

Es wird wie in Versuch A verfahren, jedoch werden 400 Teile Polyethylenoxid vom Molekulargewicht 12.000 g/Mol und 600 Teile einer Lösung von 10 Teilen Benzoylperoxid in 1500 Teilen Vinylacetat verwendet. Das Produkt hat eine Esterzahl von 53 mg/g, nach vorübergehender Dehnung auf die eineinhalbfache Ausgangslänge eine Restdehnung von 14 % und eine obere Zugspannung von 8 MPa.

Versuch C

Es wird wie in Versuch A verfahren, jedoch werden 400 Teile Polyethylenoxid mit einem mittleren Molekulargewicht 9.000 g/Mol und 800 Teile einer 1 %igen Lösung von Benzoylperoxid in Vinylacetat verwendet. Das Produkt hat eine Esterzahl von 156 mg/g, es ist relativ weich, hat aber eine sehr gute Elastizität: Restdehnung (wie unter Versuch B gemessen) 2%; Zugspannung bei 50% Dehning 2 MPa.

Versuch D

Es wird wie in Versuch C verfahren, jedoch werden zur Umesterung des Polymeren 50 Teile 10 %ige methanolische Natronlauge verwendet. Das resultierende Produkt hat eine Esterzahl von 32 mg/g. Das Produkt ist härter und hat eine höhere Reißfestigkeit als das gemäß Versuch C hergestellte. Restdehnung (wei bei Versuch C gemessen) 9%; Zugspannung bei 50 % Dehnung 4 MPa; Reißdehnung über 200 %.

Versuch E

120 Teile des nach Versuch D hergestellten, gut getrockneten Pfropfcopolymeren werden in 480 Teilen Dimethylformamid gelöst. Es werden 2,4 Teile 2,6-Di-tert.-butyl-4-methylphenol, 0,6 Teile p-Dimethylaminopyridin und 22 Teile Methacrylsäureanhydrid gegeben. Die Lösung wird 8 Stunden bei 60°C gerührt. Das Produkt wird dann in 6000 Volumenteilen Aceton ausgefällt, abfiltriert und getrocknet. Das resultierende Produkt enthält 4 Mol.% Methacrylestergruppen.

Versuch F

Es wird wie in Versuch E verfahren, jedoch werden 120 Teile des nach Versuch A hergestellten und gut getrockneten Pfropfcopolymeren, 60 Teile Methacrylsäureanhydrid und 1,8 Teile p-Dimethylaminopyridin verwendet. Das resultierende Produkt enthält 11 Mol.% Methacrylestergruppen.

Versuch G

Es wird wie in Versuch D verfahren, jedoch werden 400 Teile eines Polyethylenoxids mit einem mittleren Molekulargewicht von 35.000 g/Mol sowie 400 Teile einer 0,75 %igen Lösung von Benzoylperoxid in Vinylacetat verwendet. Das resultierende Produkt hat eine Esterzahl von 13 mg/g und zeigt eine gute Elastizität. Zur Dehnung eines entsprechenden Probekörpers auf das Doppelte seiner Ausgangslänge ist eine Spannung von 4,9 MPa erforderlich; nach Entlastung verbleibt eine Restdehnung von ca. 30 %.

Versuch H

Es wird wie in Versuch G verfahren, jedoch werden 800 Teile einer 1 %igen Lösung von Benzoylperoxid in Vinylacetat verwendet. Das resultierende Pfropfcopolymerisat zeigt im Vergleich zu dem gemäß Versuch G hergestellten bei etwa gleicher Härte ein verbessertes Rückstellverhalten. Die Restdehnung des Probekörpers nach Dehnung um 100 % der Ausgangslänge und anschließender Entlastung beträgt etwa 13 %.

Herstellung und Verarbeitung erfindungsgemäßer Aufzeichnungsmaterialien

Beispiel 1

Aus 77,1 Teilen eines gemäß Versuch A hergestellten Pfropfcopolymerisats, 10 Teilen Ethylenglykol, 10 Teilen Tetraethylenglykoldiacrylat, 2 Teilen Benzildimethylketal, 0,03 Teilen des Farbstoffs Duasyn Basisch Rot TM (C.I. 50240), 0,4 Teilen des Kaliumsalzes des N-Nitrosocyclohexylhydroxylamins und 0,5 Teilen 2,6-Di-tert.butyl-p-kresol wird durch Kneten in einem Plastographen bei 130°C ein photoempfindliches Aufzeichnungsmaterial hergestellt. Die Mischung wird bei 130°C so auf einen Stahlträger gepreßt, daß eine Schicht von ca. 1000 µm Dicke resultiert. Danach wird die Schicht 15 min direkt durch ein Negativ belichtet und 3 min bei 40°C in einem Sprühwascher mit reinem Wasser entwickelt. Nach dem Trocknen erhält man ein elastisches Relief mit einer glatten, klebfreien Oberfläche mit einer Shore A-Härte von 90.

Beispiel 2

Wie in Beispiel 1 wird eine Mischung hergestellt aus 77,1 Teilen eines gemäß Versuch A hergestellten Pfropfcopolymerisats, 10 Teilen Methylpolyethylenglykol-acrylat (ca. 14 Ethylenglykol-Struktureinheiten im Molekül), 10 Teilen Tetraethylenglykolmonoacrylat und 2 Teilen Benzildimethylketal. Die Mischung wird bei 130°C so auf eine 125 µm starke Polyesterfolie gepreßt, daß eine Schicht einer Stärke von ca. 1000 µm resultiert. Danach wird die Schicht 15 min durch ein Negativ belichtet und 2 min in einem Sprühwascher mit reinem Wasser entwickelt. Man erhält nach dem Trocknen ein Relief mit einer Shore A-Härte von 82. Die Gewichtsquellung in für den Flexodruck typischen Ölfarben beträgt weniger als 6 %.

Beispiel 3

Wie in Beispiel 1 wird eine Mischung hergestellt aus 67 Teilen eines gemäß Versuch B hergestellten Pfropfcopolymerisats, 20 Teilen Ethylenglykol, 10 Teilen Tetraethylenglykolmonoacrylat, 3 Teilen 2,4,6-Trimethylbenzoyl-diphenylphosphinoxid und zu einer Schicht auf einem Stahlblech verarbeitet. Die Schicht wird 15 min bildmäßig belichtet und dann 3 min durch Waschen mit Wasser entwickelt. Das resultierende Klischee hat eine Shore A-Härte von 70 und seine Gewichtsquellung in für den Flexodruck typischen Ölfarben beträgt 2 %.

Beispiel 4

78,1 Teile eines Pfropfcopolymerisats gemäß Versuch E, 20 Teile Tetraethylenglykoldiacrylat, 1 Teil Benzildimethylketal, 0,5 Teile 2,6-Di-tert.butyl-p-kresol, 0,4 Teile des Kaliumsalzes von N-Nitroso-cyclohexylhydroxylamin und 0,03 Teile des Farbstoffs Duasyn Basisch Rot TH (C.I. 50240) werden in einer n-Propanol/Wasser-Mischung (Volumenverhältnis 1:5) gelöst. Die Lösung wird so auf einer 125 µm starken Polyesterfolie vergossen, daß eine Trockenschichtdicke von ca. 1000 µm resultiert. Dann wird die Schicht 20 min bildmäßig belichtet und 5 min in einem Sprühwascher mit reinem Wasser entwickelt. Das getrocknete Klischee hat eine Shore D-Härte von 67.

Beispiel 5

74,2 Teile eines gemäß Versuch B hergestellten Pfropfcopolymerisats, 12 Teile eines Triethers aus Glycerin mit 3 Mol N-Methylolacrylamid, 8 Teile des Dimethacrylats eines Polyethylenglykols mit im Mittel 14 Ethylenglykoleinheiten, 1,5 Teile Benzoinisopropylether, 0,3 Teile Hydrochinonmonomethylether, 4 Teile N-n-Butyl-benzolsulfonamid werden mit 16 ppm Dibenzanthron versetzt und in einer Mischung von 40 % Methanol und 60 % Wasser gelöst. Die Lösung wird mittels einer Rakelvorrichtung in einer solchen Naßschichtdicke auf ein mit Grundier- und Oberlack versehenes Stahlträgerblech aufgetragen, daß nach der Trocknung bei meist 50°C für 2 Stunden und dann 80°C für 22 Stunden eine Trockenschichtdicke von 0,3 mm verbleibt. Die Restfeuchte wird auf 5 ± 0.3 % eingestellt. Die Schicht ist transparent und an der Oberfläche nicht klebrig. Nach der bildmäßigen Belichtung mit einem mit Eisen dotierten Quecksilberbrenner von 5 kW Leistungsaufnahme für 90 Sekunden wird mit handwarmem Wasser milde ausgewaschen, wobei eine einwandfreie Reliefstruktur resultiert. Nach der Trocknung des Klischees für 10 Minuten bei 90°C unter gleichzeitiger Nachbelichtung mit dem Licht adaptierter Neonröhren wird

eine Druckplatte erhalten, die in einer Flachbettdruckmaschine mit Ölfarbe ausgezeichnete Drucke auf sehr rauhen und dünnen Zeitungspapieren liefert. Die photopolymerisierte Schicht weist nach DIN 53305 eine Shore A-Härte von 72 auf.

<u>Beispiel 6</u>

Es wird wie in Beispiel 5 verfahren, jedoch ein gemäß Versuch A hergestelltes Pfropfcopolymerisat verwendet. Es resultiert eine vergleichbar gute elastische Druckplatte mit einer Shore A-Härte von 83. Mit ihr werden ausgezeichnete Druckergebnisse erzielt.

<u>Beispiel 7</u>

48,9 Teile eines gemäß Versuch G hergestellten Pfropfcopolymerisats, 24,5 Teile N-n-Butyl-benzolsulfonamid, 24,5 Teile eines Reaktionsprodukts von 1 Mol 1,4-Butandiol-diglycidylether mit 2 Molen Acrylsäure, 1,2 Teile Benzildimethylketal, 0,03 Teile des Farbstoffs Duasyn Basisch Rot TH (C.I. 50240), 0,5 Teile 2,6-Di-tert.butyl-p-kresol und 0,4 Teile des Kaliumsalzes von N-Nitrosocyclohexyl-hydroxylamin werden in einer n-Propanol/Wasser-Mischung (Volumenverhältnis 1:3) gelöst. Die Lösung wird auf eine Polyesterfolie so gegossen, daß eine Schicht einer Trockenschichtstärke von 700 µm resultiert. Die Schicht wird dann auf eine weichelastische, von einer 75 µm Polyesterfolie begrenzten Trägerschicht aufkaschiert. Durch 20 s Rückseitenbelichtung, 15 min bildmäßige Hauptbelichtung, 5 min Entwickeln mit Wasser in einem Sprühwascher und Trocknen wird ein weichelastisches Druckklischee hergestellt, dessen photopolymerisierte Schicht eine Shore A-Härte von 50 hat.

**Patentansprüche für die Vertragsstaaten: BE, CH, DE, FR, GB, IT, LI, NL, SE**

1. In wäßrigen Lösungsmitteln entwickelbare, photovernetzbare oder photopolymerisierbare elastomere Aufzeichnungsmaterialien enthaltend
a) mindestens ein polymeres Bindemittel,
b) gegebenenfalls mindestens eine mit dem Bindemittel verträgliche photopolymerisierbare olefinisch ungesättigte Verbindung sowie
c) mindestens einen Photoinitiator,
<u>dadurch gekennzeichnet</u>, daß sie als polymeres Bindemittel ein in einem wäßrigen Lösungsmittel lösliches oder dispergierbares elastomeres Pfropfpolymerisat enthalten, das durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt ist und im wesentlichen besteht aus Struktureinheiten der Zusammensetzung

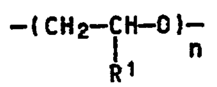 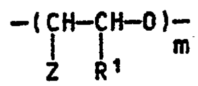 .

worin Z: aufgepfropfte Seitenzweige mit Struktureinheiten

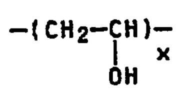 und ggf. 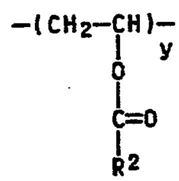 ,

$R^1$ Wasserstoff und/oder Alkylreste mit 1 oder 2 C-Atomen,
$R^2$ Alkyl- und/oder Alkenylreste, gegebenenfalls mit Carboxylsubstituenten, darstellen,
und $x > y$, $n > m$, $m$ mindestens 2, $n + m = 20\text{-}2000$, und

$$\frac{(n+m)}{(x+y)} = \frac{1}{4} \text{ bis } \frac{3}{1} \text{ sind.}$$

2. Aufzeichnungsmaterialien gemäß Anspruch 1, <u>dadurch gekennzeichnet</u>, daß in den Struktureinheiten des elastomeren Pfropfcopolymerisats mindestens 50 Mol.% der Reste $R^1$ Wasserstoff ist.

3. Aufzeichnungsmaterialien gemäß Anspruch 1 oder 2, <u>dadurch gekennzeichnet</u>, daß die Restdehnung des Pfropfcopolymerisats nach 100 % Dehnung und anschließender Entlastung weniger als 30 % beträgt.

4. Reliefformen, hergestellt durch bildmäßige Belichtung von Schichten aus elastomeren Aufzeichnungsmaterialien gemäß Anspruch 1 und Entfernen der unbelichteten Schichtanteile.

5. Verwendung von mit dimensionsstabilen Trägern verbundenen Reliefformen gemäß Anspruch 4 als Druckformen für den Flexodruck.

**Patentansprüche für die Vertragsstaaten: AT, ES**

1. Verfahren zur Herstellung von Reliefformen oder Flexodruckformen, bei dem man Schichten aus

A) in wäßrigen Lösungsmitteln entwickelbaren, photovernetzbaren oder photopolymerisierbaren elastomeren Aufzeichnungsmaterialien, welche

a) mindestens ein polymeres Bindemittel,

b) gegebenenfalls mindestens eine mit dem Bindemittel verträgliche photopolymerisierbare olefinisch ungesättigte Verbindung sowie

c) mindestens einen Photoinitiator, enthalten,

B) bildmäßig belichtet und anschließend

C) die unbelichteten Schichtanteile durch Waschen mit wäßrigen Lösungsmitteln entfernt,

dadurch gekennzeichnet, daß man hierbei als polymeres Bindemitttel (a) oder eines der polymeren Bindemittel (a) der elastomeren Aufzeichnungsmaterialien (A) ein in einem wäßrigen Lösungsmittel lösliches oder dispergierbares elastomeres Pfropfcopolymerisat verwendet, welches durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt worden ist und welches im wesentlichen besteht aus Struktureinheiten der Zusammensetzung

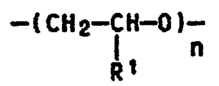
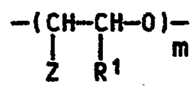 ,

worin Z: aufgepfropfte Seitenzweige mit Struktureinheiten

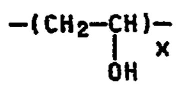
und ggf.
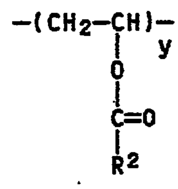 ,

$R^1$ Wasserstoff und/oder Alkylreste mit 1 oder 2 C-Atomen,

$R^2$ Alkyl- und/oder Alkenylreste, gegebenenfalls mit Carboxylsubstituenten, darstellen,

und $x > y$, $n > m$, $m$ mindestens 2, $n + m = 20\text{-}2000$, und

$$\frac{(n+m)}{(x+y)} = \frac{1}{4} \text{ bis } \frac{3}{1} \text{ sind.}$$

2. Verfahren nach Anspruch 1, dadurch gekennzeichnet, daß man hierbei ein elastomeres Pfropfcopolymerisat verwendet, in dessen Struktureinheiten mindestens 50 Mol.% der Reste $R^1$ Wasserstoff ist.

3. Verfahren nach einem der Ansprüche 1 oder 2, dadurch gekennzeichnet, daß man hierbei ein elastomeres Pfropfcopolymerisat verwendet, dessen Restdehnung nach 100 %iger Dehnung und anschließender Entlastung weniger als 30 % beträgt.

4. Verfahren nach einem der Ansprüche 1, 2 oder 3, dadurch gekennzeichnet, daß die Schichten aus elastomeren Aufzeichnungsmaterialien (A) mit dimensionsstabilen Trägern verbunden sind.

**Claims for the Contracting States: BE, CH, DE, FR, GB, IT, LI, NL, SE**

1. A photocrosslinkable or photopolymerizable elastomeric recording material which can be developed in aqueous solvents and contains

a) one or more polymeric binders,

b) if required, one or more photopolymerizable olefinically unsaturated compounds which are compatible with the binder, and

c) one or more photoinitiators,

wherein the said recording material contains, as the polymeric binder, an elastomeric graft polymer which is soluble or dispersible in an aqueous solvent and is prepared by polymerization of vinyl esters in the

presence of polyalkylene oxides and a free radical polymerization initiator, hydrolysis or partial hydrolysis of the resulting graft copolymer and, if required, subsequent esterification or transesterification of vinyl alcohol units of the hydrolyzed or partially hydrolyzed graft copolymer, and essentially consists of structural units having the composition

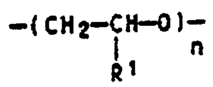

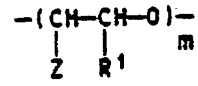

where Z is a grafted branch containing structural units

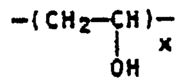

and, if appropriate

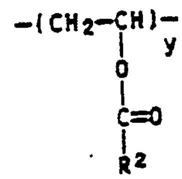

$R^1$ is hydrogen and/or alkyl of 1 or 2 carbon atoms, $R^2$ is alkyl and/or alkenyl, and these radicals $R^2$ may carry carboxyl substituents, $x > y$, $n > m$, m is not less than 2, $n + m = 20–2000$ and

$$\frac{(n + m)}{(x + y)} = \text{from } \frac{1}{4} \text{ to } \frac{3}{1}$$

2. A recording material as claimed in claim 1, wherein, in the structural units of the elastomeric graft copolymer, not less than 50 mol% of the radicals $R^1$ are hydrogen.

3. A recording material as claimed in claim 1 or 2, wherein the residual elongation of the graft copolymer after 100% elongation and subsequent removal of the load is less than 30%.

4. A relief plate produced by imagewise exposure of a layer of an elastomeric recording material as claimed in claim 1 and removal of the unexposed parts of the layer.

5. Use of a relief plate as claimed in claim 4, bonded to a dimensionally stable base, as a flexographic printing plate.

**Claims for the Contracting States: AT, ES**

1. A process for the production of a relief plate or flexographic printing plate, in which a layer of

A) a photocrosslinkable or photopolymerizable elastomeric recording material which can be developed in aqueous solvents and contains

  a) one or more polymeric binders,

  b) if required, one or more photopolymerizable olefinically unsaturated compounds which are compatible with the binder, and

  c) one or more photoinitiators,

B) is exposed imagewise and subsequently

C) the unexposed parts of the layer are removed by washing with aqueous solvents,

wherein the polymeric binder (a) or one of the polymeric binders (a) used in the elastomeric recording material (A) is an elastomeric graft copolymer which is soluble or dispersible in an aqueous solvent and has been prepared by polymerization of vinyl esters in the presence of polyalkylene oxides and a free radical polymerization initiator, hydrolysis or partial hydrolysis of the resulting graft copolymer and, if required, subsequent esterification or transesterification of vinyl alcohol units of the hydrolyzed or partially hydrolyzed graft copolymer, and essentially consists of structural units having the composition

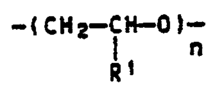

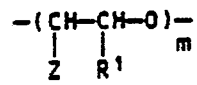

where Z is a grafted branch containing structural units

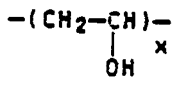 and, if appropriate 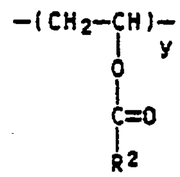

$R^1$ is hydrogen and/or alkyl of 1 or 2 carbon atoms, $R^2$ is alkyl and/or alkylene and these radicals $R^2$ may carry carboxyl substituents, $x > y$, $n > m$, m is not less than 2, $n + m = 20\text{-}2000$ and

$$\frac{(n + m)}{(x + y)} = \text{from } \frac{1}{4} \text{ to } \frac{3}{1}$$

2. A process as claimed in claim 1, wherein an elastomeric graft copolymer is used, in the structural units of which not less than 50 mol% of the radicals $R^1$ are hydrogen.

3. A process as claimed in claim 1 or 2, wherein an elastomeric graft copolymer is used, the residual elongation of which after 100% elongation and subsequent removal of the load is less than 30%.

4. A process as claimed in claim 1, 2 or 3, wherein the layer of elastomeric recording material (A) is bonded to a dimensionally stable base.

**Revendications pour les Etats contractants: BE, CH, DE, FR, GB, IT, LI, NL, SE**

1. Matériaux d'enregistrement élastomères photoréticulables ou photopolymérisables, développables dans des solvants aqueux, qui contiennent

a) au moins un liant polymère,

b) éventuellement au moins un composé photopolymérisable à insaturation oléfinique, compatible avec le liant, ainsi que

c) au moins un photo-initiateur,

caractérisés par le fait qu'ils contiennent, comme liant polymère, un polymérisat de greffage élastomère soluble ou dispersable dans un solvant aqueux qui est préparé par polymérisation d'esters vinyliques en présence d'oxydes de polyalkylène et d'un initiateur de polymérisation radicalaire, saponification ou saponification partielle du copolymérisat de greffage résultant et éventuellement estérification ou réestérification subséquentes d'unités d'alcool vinylique du copolymérisat de greffage saponifié ou partiellement saponifié, et qui est composé essentiellement d'unités structurales de composition :

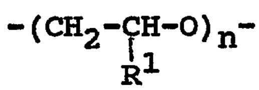 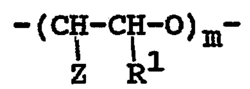

où Z représente des branches latérales greffées, à unités structurales

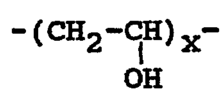 et éventuellement 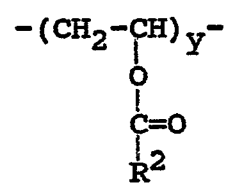

$R^1$, hydrogène et/ou des restes alkyle à 1 ou 2 atomes C,
$R^2$, des restes alkyle et/ou alcényle, éventuellement à substituants carbonyle
et x étant $> y$, $n > m$, m au moins 2, $n + m = 20\text{-}2000$, et

$$\frac{(n+m)}{(x+y)} = \frac{1}{4} \text{ à } \frac{3}{1}$$

2. Matériaux d'enregistrement selon la revendication 1, caractérisés par le fait que, dans les unités structurales du copolymérisat par greffage elastomère, 50 % (moles) des restes $R^1$ est de l'hydrogène.

3. Matériaux d'enregistrement selon la revendication 1 ou 2, caractérisés par le fait que l'allongement permanent du copolymérisat par greffage, après allongement de 100 % et décharge subséquente, s'élève à moins de 30 %.

4. Clichés en relief, fabriqués par exposition à la lumière, selon une image, de couches de matériaux d'enregistrement élastomères selon la revendication 1 et enlèvement des parties de couches non exposées à la lumière.

5. Utilisation de clichés en relief selon la revendication 4 liés à des supports stables en dimensions, comme clichés pour flexographie.

**Revendications pour les Etats contractants: AT, ES**

1. Procédé de préparation de clichés en relief ou de clichés pour flexographie, avec lequel des couches de

A) matériaux d'enregistrement élastomères photoréticulables ou photopolymérisables, développables dans des solvants aqueux, qui contiennent

a) au moins un liant polymère,

b) éventuellement au moins un composé photopolymérisable à insaturation oléfinique, compatible avec le liant, ainsi que

c) au moins un photo-initiateur,

B) sont exposées à la lumière selon l'image, puis

C) les parties de couche non exposées sont éliminées par lavage avec des solvants aqueux,

caractérisé par le fait que l'on utilise, comme liant polymère (a) ou un des liants polymères (a) des matériaux d'enregistrement élastomères (A), un copolymérisat de greffage élastomère soluble ou dispersable dans un solvant aqueux, qui a été préparé par polymérisation d'esters vinyliques en présence d'oxydes de polyalkylène et d'un initiateur de polymérisation radicalaire, saponification ou saponification partielle du copolymérisat de greffage résultant et éventuellement estérification ou réestérification subséquentes d'unités d'alcool vinylique du copolymérisat de greffage saponifié ou partiellement saponifié, et qui est composé essentiellement d'unités structurales de composition

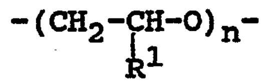 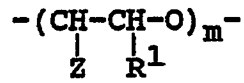

où Z représente des branches latérales greffées, à unités structurales

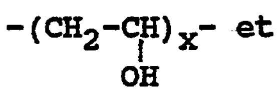 et éventuellement 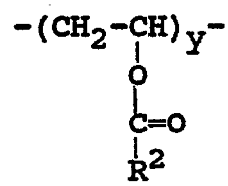

$R^1$, hydrogène et/ou des restes alkyle à 1 ou 2 atomes C,
$R^2$, des restes alkyle et/ou alcényle, éventuellement à substituants carbonyle
et x étant > y, n > m, m au moins 2, n + m = 20-2000, et

$$\frac{(n+m)}{(x+y)} = \frac{1}{4} \text{ à } \frac{3}{1}$$

2. Procédé selon la revendication 1, caractérisé par le fait que l'on utilise un copolymérisat de greffage élastomère dont les restes $R^1$ des unités structurales sont composés d'au moins 50 % (moles) d'hydrogène.

3. Procédé selon l'une des revendications 1 ou 2, caractérisé par le fait que l'on utilise un copolymérisat de greffage élastomère dont l'allongement permanent, après allongement de 100 % et décharge subséquente, s'élève à moins de 30 %.

4. Procédé selon l'une des revendications 1, 2 ou 3, caractérisé par le fait que les couches en matériaux d'enregistrement élastomères (A) sont liées à des supports à stabilité dimensionnelle.